# EUROPÄISCHE PATENTSCHRIFT

(11) **EP 3 557 632 B1**
(45) Veröffentlichungstag und Bekanntmachung des Hinweises auf die Patenterteilung: **16.12.2020**
(21) Anmeldenummer: 19000270.9
(22) Anmeldetag: 19.03.2018
(51) Int. Cl.: H01L 29/861, H01L 29/872, H01L 29/20, H01L 29/32, H01L 29/36, H01L 21/329

(54) **III-V-HALBLEITERDIODE AUF GAAS BASIS**
GAAS-BASED III-V SEMICONDUCTOR DIODE
DIODE SEMI-CONDUCTRICE III-V À BASE DE GAAS

(30) Priorität: 24.03.2017 DE 102017002936
(43) Veröffentlichungstag der Anmeldung: 23.10.2019
(62) Teilanmeldung aus: 18000268.5
(73) Patentinhaber: 3-5 Power Electronics GmbH, 01217 Dresden (DE)
(72) Erfinder: Dudek, Volker, 76275 Ettlingen (DE)
(74) Vertreter: Koch Müller Patentanwaltsgesellschaft mbH

(56) Entgegenhaltungen:
- EP-A2- 3 503 204
- DE-A1-102014 223 315
- US-A- 5 733 815
- US-A1- 2006 281 263
- YU SOLDATENKOV F ET AL: "GaAs- ABheterostructures for high-speed power diodes manufacturing", JOURNAL OF PHYSICS: CONFERENCE SERIES, INSTITUTE OF PHYSICS PUBLISHING, BRISTOL, GB, Bd. 661, Nr. 1, 2. Dezember 2015 (2015-12-02), Seite 12066, XP020290808, ISSN: 1742-6596, DOI: 10.1088/1742-6596/661/1/012066 [gefunden am 2015-12-02]
- G Ashkinaw ET AL: "Solid-State Ekch~~ies PROCESS AND DEVICE CHARACTERIZATION OF HIGH VOLTAGE GALLIUM ARSENIDE P-i-N LAYERS GROWN BY AN IMPROVED LIQUID PHASE EPITAXY METHOD", , 1. Januar 1993 (1993-01-01), Seiten 1749-1755, XP055498521, Gefunden im Internet: URL:https://ac.els-cdn.com/003811019390222 C/1-s2.0-003811019390222C-main.pdf?_tid=72 33ad54-efe8-4ea2-88c8-5e338494f1ea&acdnat= 1533743034_2745cb1569513a6a36b78720a87bc23 6
- A. Koel: "Characterization of the temperature dependent behavior of snappy phenomenon by the switching-off of GaAs power diode structures", Advances in Fluid Mechanics XI, vol. 1, 1 July 2014 (2014-07-01), pages 439-449, XP055545469, Southampton UK ISSN: 1746-4471, DOI: 10.2495/HT140381 ISBN: 978-1-78466-105-2

## Beschreibung

Die Erfindung betrifft eine III-V-Halbleiterdiode.

Aus "GaAs Power Devices" von German Ashkinazi, ISBN 965-7094-19-4, Seite 8 und 9 ist eine hochspannungsfeste Halbleiterdiode p⁺ - n - n⁺ bekannt. Es ist wünschenswert, dass hochspannungsfeste Halbleiterdioden neben der hohen Spannungsfestigkeit sowohl niedrige Durchschaltwiderstände als auch geringe Leckströme im Sperrbereich aufweisen.

Aus "GaAs-A3B5 heterosructures for high -speed power diodes manufacturing", F. Yu Soldatenkov et al., Journal of Physics: Conference Series, Institute of Physics publishing, Bristol, GB, Bd. 661, Nr.1, 02.12.2015, S. 12066, SP020290808, ISSN: 10.1088/1742-6596/661/ 1/012066 sowie aus der US 5 733 815 A oder der EP 3 503 204 A2 sind p-i-n Diodenstruktur aus GaAs-Verbindungen bekannt. Der Artikel von Soldatenkov et. al. offenbart eine Diode, die aus der Stapelung einer hochdotierten p-Schicht, einer niedrig dotierten p-Schicht, einer intrinsischen Schicht, einer niedrig dotierten n-Schicht und einer hochdotierten n-Schicht besteht.

Eine Silizium-basierte Diodenstruktur mit Defekten ist aus der US 2006/281263 A1 bekannt.

Aus A.Koel: "Characterization of the temperature dependent behavior of snappy phenomenon by the switching-off of GaAs power diode structures", Adavances in Fluid Mechanics XI, Bd. 1, 1. Juli 2014, Seiten 439-449, XP 055545469, Southampton UK ISSN: 1746-4471, ISBN: 978-1-78466-105-2 ist eine GaAs Power Diode bekannt.

Vor diesem Hintergrund besteht die Aufgabe der Erfindung darin, eine Vorrichtung anzugeben, die den Stand der Technik weiterbildet.

Die Aufgabe wird durch eine III-V-Halbleiterdiode mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige III-V-Halbleiterdiode gemäß Anspruch 1 bereitgestellt.

Im Folgenden werden die Begriffe Zwischenschicht und p-Schicht synonym verwendet.

Es sei angemerkt, dass die Schichten mittels einer Flüssigphasenepitaxie oder mittels einer MOVPE Anlage hergestellt werden.

Es versteht sich, dass die Defektschicht sich auf unterschiedliche Weise, beispielsweise durch Implantation oder mittels Einbau von Fremdatomen erzeugen lässt und innerhalb der Defektschicht eine Rekombination von Ladungsträger erreicht wird.

Auch sei angemerkt, dass die Defektschicht möglichst nicht innerhalb der Raumladungszone ausgebildet ist. Vorzugsweise ist die Dicke der p-Schicht derart ausgebildet, so dass die Defektschicht von der Raumladungszone beabstandet ist.

Ein Vorteil ist, dass sich mittels des Einbaus der Defektschicht die Höhe der Leckströme im Sperrbereich reduzieren lässt, während im Durchlassbereich sich die Bauelementeeigenschaften nahezu unbeeinflusst sind. Insbesondere im Sperrbereich bei Spannung oberhalb 1000V machen sich Leckströme nachteilig bemerkbar.

Ferner steigen die Leckströme mit der Temperatur stark an. Durch den Einbau der Defektschicht lassen sich die Leckströme um mehr als eine Größenordnung gegenüber Dioden ohne Defektschicht reduzieren. Des Weiteren wird der Herstellungsprozess wesentlich robuster, d.h. unempfindlich gegen eine hohe Hintergrunddotierung.

Ein weiterer Vorteil ist, dass sich mit der erfindungsgemäßen III-V-Halbleiterdiode auf einfache Weise niedrige Leckströme bei Sperrspannungen in einem Bereich von 200V - 3300 V mit kleineren Einschaltwiderständen und geringeren Kapazitäten pro Fläche als herkömmliche hochsperrende Dioden aus Si oder aus SiC herstellen lassen. Hierdurch sind Schaltfrequenzen von 30 kHz bis zu 0,5 GHz und Stromdichten von 0,5 A/mm² bis 5 A/mm² erreichbar.

Ein anderer Vorteil ist, dass sich die III-V-Halbleiterdioden kostengünstiger als vergleichbare hochsperrende Dioden aus SiC herstellen lassen.

Insbesondere lassen sich die erfindungsgemäßen III-V-Halbleiterdioden als Freilaufdioden verwenden.

Es sei angemerkt, dass die erfindungsgemäßen III-V-Halbleiterdioden vorliegend kleine Einschaltwiderstände in einem Bereich zwischen 1 mOhm und 200 mOhm aufweisen. Die Kapazitäten pro Fläche liegen in einem Bereich zwischen 2 pF und 100 pF.

Ein anderer Vorteil der erfindungsgemäßen III-V-Halbleiterdiode ist eine hohe Temperaturfestigkeit von bis zu 300°C. Anders ausgedrückt lassen sich die III-V-Halbleiterdioden auch in heißen Umgebungen einsetzten. Hierbei sind niedrige Leckströme aufgrund des exponentiellen Anstiegs mit steigender Temperatur besonders hilfreich.

In einer ersten Ausführungsform weist die erste Defektschicht einen Abstand zu der Unterseite der p⁻-Schicht von mindestens der Hälfte der Schichtdicke der p-Schicht auf.

Gemäß einer Weiterbildung weist die Halbleiterdiode eine zweite Defektschicht auf, wobei die zweite Defektschicht eine Schichtdicke in einem Bereich zwischen 0,5 µm und 40 µm, vorzugsweise in einem Bereich zwischen 0,5 und 40 µm und eine Defektkonzentration im einem Bereich zwischen 1•10¹³N/ cm³ und 5•10¹⁶ N/cm³ aufweist und einen Abstand zu der Oberseite der p-Schicht von höchstens der Hälfte der Schichtdicke der p-Schicht aufweist. Vorzugsweise unterscheidet sich die Defektkonzentration der ersten Defektschicht von der zweiten Defektschicht.

In einer weiteren Ausführungsform weist die erste Defektschicht und/oder eine zweite Defektschicht mindestens einen ersten Schichtbereich mit einer ersten Defektkonzentration und einen zweiten Schichtbereich mit einer zweiten Defektkonzentration auf und folgt insbesondere über die Schichtdicke der ersten Defektschicht und/oder einer zweiten Defektschicht einer statistischen vorzugsweise Gauß-Verteilung. Anders ausgedrückt ist die Defektkonzentration entlang der Dicke der Defektschicht unterschiedlich.

Gemäß einer anderen Ausführungsform umfassen die erste Defektschicht und / oder die zweite Defektschicht Cr und/oder Indium und/oder Aluminium. Vorzugsweise wird Cr während des Epitaxieprozesses in die n⁻-Schicht eingebaut. Ein Vorteil des Einbaus von Cr ist, dass mittels der Konzentration von Cr sich die Anzahl der Störstellen und hierdurch die Anzahl der Rekombinationszentren kostengünstig und auf einfache Weise einstellen lässt, ohne dass der Epitaxieprozess unterbrochen wird.

In einer anderen Ausführungsform sind in der ersten Defektschicht und / oder in der zweiten Defektschicht die Störstellen durch eine Implantation von Atomen oder Molekülen oder durch eine Elektronenstrahl-Bestrahlung erzeugt. Vorzugsweise wird zur Erzeugung von Störstellen H₂ Moleküle mit der entsprechenden Energie und Dosis verwendet.

Gemäß einer weiteren Ausführungsform beträgt eine Gesamthöhe des stapelförmigen Schichtaufbaus bestehend aus der p⁺-Schicht, der p-dotierten Zwischenschicht, der n⁻-Schicht und der n⁺-Schicht zwischen 150-800 µm.

Gemäß alternativer Ausführungsformen weist der stapelförmige Schichtaufbau bestehend aus der p⁺-Schicht, der p-dotierten Zwischenschicht, der n⁻-Schicht und der n⁺-Schicht eine rechteckige oder quadratische Oberfläche mit Kantenlängen zwischen 1 mm und 10 mm oder eine runde, vorzugsweise ovale oder kreisförmige Oberfläche auf.

Gemäß einer nicht erfindungsgemäßen Ausführungsform ist die p⁺-Schicht der Halbleiterdiode durch eine Anschlusskontaktschicht ersetzt, wobei die Anschlusskontaktschicht ein Metall oder eine metallische Verbindung umfasst oder aus einem Metall oder einer metallischen Verbindung besteht und einen Schottky-Kontakt ausbildet.

In einer Weiterbildung ist die III-V-Halbleiterdiode monolithisch ausgebildet, d.h. die einzelnen monolithisch ausgebildeten Schichten sind zueinander ebenfalls monolithisch ausgebildet. In einer anderen Ausführungsform umfasst die III-V Halbleiterdiode wenigstens einen Halbleiterbond.

Es wird angemerkt, dass der Ausdruck Halbleiterbond synonym mit dem Ausdruck Waferbond verwendet wird.

In einer weiteren Ausführungsform ist der Halbleiterbond bei dem stapelförmigen Schichtaufbau, bestehend aus dem p⁺-Schicht, der p-dotierten Zwischenschicht, der n⁻-Schicht und der n⁺-Schicht, zwischen der n⁻-Schicht und der p-dotierten Zwischenschicht ausgebildet.

In einer Ausführungsform bildet der Schichtaufbau bestehend aus einem p⁺-Schicht und der p-dotierten Zwischenschicht einen ersten Teilstapel und der Schichtaufbau bestehend aus der n⁺-Schicht und der n⁻-Schicht einen zweiten Teilstapel.

In einer Weiterbildung wird der erste Teilstapel gebildet, in dem ausgehend von einem p⁺-Schicht mittels Epitaxie die p-dotierten Zwischenschicht hergestellt wird.

Vorzugsweise weist die als p⁻-Schicht ausgebildete Zwischenschicht eine Dotierung kleiner als 10¹³ N/cm⁻³ oder eine Dotierung zwischen 10¹³ N/cm⁻³ und 10¹⁵ N/cm⁻³ auf. In einer Ausführungsform wird das p⁺-Schicht vor oder nach dem Bonden durch einen Schleifprozess auf eine Dicke zwischen 200 µm und 500 µm gedünnt.

In einer Weiterbildung sind der erste Teilstapel und der zweite Teilstapel jeweils monolithisch ausgebildet.

In einer Ausführungsform wird der zweite Stapel gebildet, in dem ausgehend von einem n⁻-Substrat, das n⁻-Substrat mit dem zweiten Stapel durch einen weiteren Waferbondprozess verbunden wird.

In einem weiteren Prozessschritt wird das n⁻-Substrat auf die gewünschte Dicke gedünnt. Vorzugsweise liegt die Dicke des n⁻-Substrats in einem Bereich zwischen 50 µm bis 250µm. Vorzugsweise liegt die Dotierung des n⁻-Substrats in einem Bereich zwischen 10¹³ N/cm⁻³ und 10¹⁵ N/cm⁻³.

Ein Vorteil des Waferbondens ist es, dass sich dicke n⁻-Schichten ohne weiteres herstellen lassen. Ein langer Abscheideprozess bei der Epitaxie entfällt hierdurch. Auch lassen sich mittels des Bondens die Anzahl der Stapelfehler bei den dicken n⁻-Schichten verringern.

In einer anderen Weiterbildung wird vor dem Bonden die Defektschicht vorzugsweise mittels Implantation von Ionen in die Oberfläche des ersten Teilstapels, d.h. in die p-dotierten Zwischenschicht erzeugt.

In eine alternativen Ausführungsform weist das n⁻-Substrat eine Dotierung kleiner als 10¹³ N/cm⁻³ auf. In dem die Dotierung extrem gering ist, lässt sich das n⁻-Substrat auch als eine intrinsische Schicht auffassen.

In einer nicht erfindungsgemäßen Weiterbildung wird nach dem Dünnen des n⁻-Substrats mittels Epitaxie oder Hochdosisimplantation auf dem n⁻-Substrat die n⁺-Schicht in einem Bereich zwischen 10¹⁸ N/cm⁻³ und kleiner als 5x10¹⁹ N/cm⁻³ erzeugt.

Es versteht sich, dass das Dünnen des n⁻-Substrats vorzugsweise mittels eines CMP Schrittes, d.h. mittels chemischen mechanischen Polierens erfolgt.

In einer anderen Weiterbildung wird auf der Vorderseite der Dioden-Struktur eine Hilfsschicht aufgetragen. Anschließend lässt die Rückseite der Dioden-Struktur dünnen und auf einem Träger ablegen. In einer anderen Weiterbildung wird anschließend die Hilfsschicht von der Vorderseite abgelöst.

Erfindungsgemäß werden die Oberfläche des n⁺-Substrats und die Oberfläche des p⁺-Schichts metallisiert, um die Halbleiter-Diode elektrisch anzuschließen. Vorzugsweise wird die Kathode der Halbleiter-Diode nach der Metallisierung mit einer als Wärmesenke ausgebildeten Unterlage stoffschlüssig verbunden. Anders ausgedrückt, die Anode Ist an der Oberfläche der Diode auf der p⁺-Schicht ausgebildet. Untersuchungen haben gezeigt, dass sich mit bestimmten Kombinationen von einer p⁻- Zwischenschicht und n⁻-Schicht verschiedene Sperrspannungen erzielen lassen.

In einer ersten Variante umfasst die:
p⁻- Zwischenschicht eine Dicke zwischen 10 µm bis 25 µm und für die n⁻-Schicht eine Dicke zwischen 40 µm und 90 µm eine Sperrspannung von ca. 900 V ergibt.

In einer zweiten Variante umfasst die:
p⁻- Zwischenschicht eine Dicke zwischen 25 µm bis 35 µm und für die n⁻-Schicht eine Dicke zwischen 40 µm und 70 µm eine Sperrspannung von ca. 1200 V ergibt.

In einer dritten Variante umfasst die:
p⁻- Zwischenschicht eine Dicke zwischen 35 µm bis 50 µm und für die n⁻-Schicht eine Dicke zwischen 70µm und 150 µm und 70 µm eine Sperrspannung von ca. 1500 V ergibt.

Die Dioden in der ersten bis dritten Variante lassen sich auch als Punsch- Dioden bezeichnen.

In einer vierten Variante umfasst die:
p⁻- Zwischenschicht eine Dicke zwischen 10 µm bis 25 µm und für die n⁻-Schicht eine Dicke zwischen 60 µm und 110 µm.

In einer fünften Variante umfasst die:
p⁻- Zwischenschicht eine Dicke zwischen 10 µm bis 25 µm und für die n⁻-Schicht eine Dicke zwischen 70 µm und 140.

In einer sechsten Variante umfasst die:
p⁻- Zwischenschicht eine Dicke zwischen 35 µm bis 50 µm und für die n⁻-Schicht eine Dicke zwischen 80µm und 200 µm.

Die Dioden in der vierten bis sechsten Variante lassen sich auch als "non - reach - through" - Dioden bezeichnen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die:
- Figur 1: eine Ansicht einer ersten erfindungsgemäßen Ausführungsform einer III-V-Halbleiterdiode,
- Figur 2: eine Ansicht einer nicht erfindungsgemäßen rungsform einer III-V-Halbleiterdiode,
- Figur 3: eine Aufsicht auf die III-V-Halbleiterdiode aus Figur 1 oder aus Figur 2,
- Figur 4: eine Ansicht einer zweiten erfindungsgemäßen Ausführungsform einer III-V-Halbleiterdiode,
- Figur 5: eine Ansicht einer nicht erfindungsgemäßen Ausführungsform einer III-V-Halbleiterdiode.

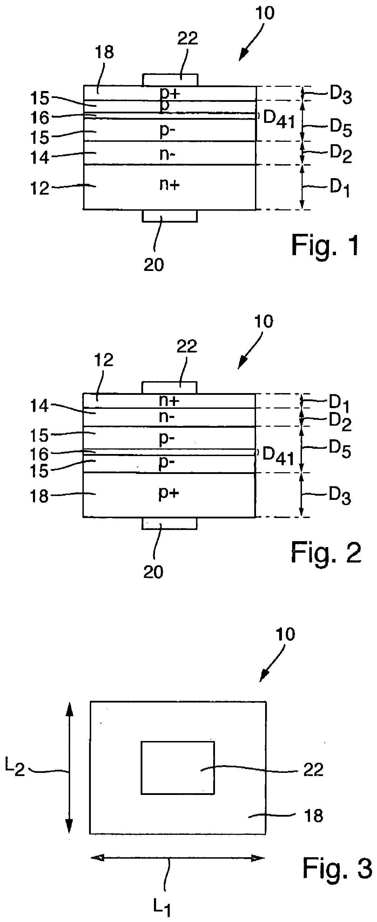

Die Abbildung der Figur 1 zeigt eine Ansicht einer ersten Ausführungsform einer erfindungsgemäßen stapelförmigen III-V-Halbleiterdiode 10, aufweisend eine n⁺-Schicht 12 als ein Substrat, eine mit der n⁺-Schicht 12 stoffschlüssig verbundene niedrig dotierte n⁻-Schicht 14 und eine mit der n⁻-Schicht 14 stoffschlüssig verbundene p-dotierte Zwischenschicht 15 und eine mit der Zwischenschicht stoffschlüssig verbundene p⁺-Schicht 18 sowie einen ersten Kontakt 20 und einen zweiten Kontakt 22. Innerhalb der p-Schicht 15 ist eine erste Defektschicht 16 angeordnet.

Der erste Kontakt 20 ist stoffschlüssig mit einer Unterseite der n⁺-Schicht 12 verbunden, während der zweite Kontakt 22 stoffschlüssig mit einer Oberseite der p⁺-Schicht 18 verbunden ist.

Die n⁺-Schicht 12 ist stark n-dotiert und weist eine Dotierstoffkonzentration von 10¹⁹ N/cm³. Eine Schichtdicke D1 der n⁺-Schicht 12 liegt zwischen 100 µm und 675 µm.

Die n⁻-Schicht 14 ist niedrig n-dotiert mit einer Dotierstoffkonzentration von 10¹²-10¹⁶ N/cm³ und weist eine Schichtdicke D2 von 10-300 µm auf.

Die p-Zwischenschicht 15 ist niedrig p-dotiert mit einer Dotierstoffkonzentration von 10¹²-10¹⁷ N/cm³ und einer Schichtdicke D5 zwischen 1 µm und 50 µm.

Die p⁺-Schicht 18 ist stark p-dotiert mit einer Dotierstoffkonzentration von 10¹⁹ N/cm³ und einer Schichtdicke D3 größer 2 µm.

Die erste Defektschicht 16 weist eine Schichtdicke D41 in einen Bereich zwischen 0,5 µm und 10 µm und eine Defektdichte im einem Bereich zwischen 1•10¹³ N/cm³ und 5•10¹⁶ N/cm³ auf.

In den Abbildungen der Figuren 2 ist eine nicht erfindungsgemäße Ausführungsform einer III-V-Halbleiterdiode dargestellt, wobei der Unterschied zu der Abbildung der Figur 1 darin liegt, dass die p⁺-Schicht 18 als Substrat ausgebildet ist, auf das die weiteren Schichten folgen.

In der Abbildung der Figuren 3 ist eine Aufsicht auf die in Figur 1 gezeigte erste Ausführungsform einer erfindungsgemäßen III-V-Halbleiterdiode dargestellt. Im Folgenden werden nur die Unterschiede zu der Abbildung der Figur 1 erläutert.

Der stapelförmige Schichtaufbau 100 der III-V-Halbleiterdiode 10 bestehend aus dem n⁺-Substrat 12, der die Defektschicht 16 umfassenden n⁻-Schicht 14 und der p⁺-Schicht 18 weist einen rechteckigen Umfang und damit auch eine rechteckige Oberfläche mit den Kantenlängen L1 und L2 auf. Die auf der Oberfläche der Schichtenfolge 100 angeordnete Kontaktfläche 22 überdeckt nur einen Teil der Oberfläche.

In einer anderen nicht dargestellten Ausführungsform sind die Ecken des stapelförmigen Schichtaufbaus 100 verrundet, um Feldstärkespitzen bei hohen Spannungen zu vermeiden.

In einer anderen nicht dargestellten Ausführungsform ist die Oberfläche des stapelförmigen Schichtaufbaus 100 rund ausgeführt. Hierdurch werden Überhöhungen der Feldstärke besonders effektiv reduziert. Vorzugsweise ist die Oberfläche kreisförmig oder oval ausgeführt.

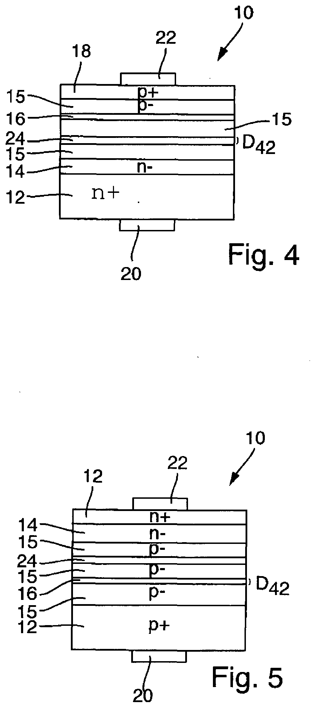

In der Abbildung der Figuren 4 ist eine Weiterbildung der III-V-Halbleiterdiode aus Figur 1 dargestellt, wobei die p-Zwischenschicht 15 der Halbleiterdiode 10 im Unterschied zu der ersten Ausführungsform eine zweite Defektschicht 24 mit einer Dicke 42 aufweist.

Die Schichtdicke D42 der zweiten Defektschicht 24 beträgt zwischen 0,5 µm und 40 µm. Die Defektkonzentration liegt zwischen 1•10¹³ N/cm³ und 5•10¹⁶ N/cm³. Der Abstand zu der Oberseite der p-Schicht weist höchstens die Hälfte der Schichtdicke D5 der Zwischenschicht auf.

In der Abbildung der Figuren 5 ist eine Weiterbildung der III-V-Halbleiterdiode aus Figur 2 dargestellt, wobei die p-Schicht 15 der Halbleiterdiode 10 im Unterschied zu der zweiten Diode der Figur 2 eine zweite Defektschicht 24 aufweist.

## Patentansprüche

1. Stapelförmige III-V-Halbleiterdiode (10), aufweisend
- eine n⁺-Schicht (12) mit einer Oberseite, einer Unterseite, einer Dotierstoffkonzentration von mindestens 10¹⁹ N/cm³ und einer Schichtdicke (D1) von 50-675 µm, wobei die n⁺-Schicht (12) eine GaAs-Verbindung umfasst oder aus einer GaAs Verbindung besteht,
- eine n⁻-Schicht (14) mit einer Oberseite und einer Unterseite, einer Dotierstoffkonzentration von 10¹²-10¹⁶ N/cm³ und einer Schichtdicke (D2) von 10-300 µm, wobei die n⁻-Schicht (14) eine GaAs-Verbindung umfasst oder aus einer GaAs Verbindung besteht,
- eine p⁺-Schicht (18) mit einer Oberseite, einer Unterseite, einer Dotierstoffkonzentration von 5•10¹⁸-5•10²⁰ N/cm³ und einer Schichtdicke (D3) größer 2 µm, wobei die p⁺-Schicht (18) eine GaAs-Verbindung umfasst oder aus einer GaAs Verbindung besteht, wobei
- die Schichten in der genannten Reihenfolge aufeinander folgen und monolithisch ausgebildet sind,
- die n⁺-Schicht (12) als Substrat ausgebildet ist und
- die Unterseite der n⁻-Schicht (14) stoffschlüssig mit der Oberseite der n⁺-Schicht (12) verbunden ist,
zwischen der n⁻-Schicht (14) und der p⁺-Schicht (18) eine p-dotierte Zwischenschicht (15) mit einer Schichtdicke (D5) von 1-50 µm und einer Dotierstoffkonzentration von 10¹²-10¹⁷ N/cm³ angeordnet ist, und mit einer Oberseite und einer Unterseite, wobei die Unterseite der p-dotierte Zwischenschicht (15) mit der Oberseite der n⁻-Schicht (14) stoffschlüssig verbunden ist und die Oberseite der p-dotierte Zwischenschicht mit der Unterseite der p⁺-Schicht (18) stoffschlüssig verbunden ist, worin die stapelförmige III-V-Halbleiterdiode (10) eine erste Defektschicht (16) mit einer Schichtdicke (D41) zwischen 0,5 µm und 40 µm aufweist,
- wobei die erste Defektschicht (16) innerhalb der p-dotierten Zwischenschicht (15) angeordnet ist,
- die erste Defektschicht (16) eine Defektkonzentration in einem Bereich zwischen 1•10¹³ N/cm³ und 5•10¹⁶ N/cm³ aufweist, und ein erster Kontakt (20) stoffschlüssig mit einer Unterseite der n⁺-Schicht (12) verbunden ist und ein zweiter Kontakt (22) stoffschlüssig mit einer Oberseite der p⁺-Schicht (18) verbunden ist.

2. III-V-Halbleiterdiode (10) nach Anspruch 1, **dadurch gekennzeichnet, dass** die Halbleiterdiode (10) eine zweite Defektschicht (24) innerhalb der p-dotierten Zwischenschicht (15) aufweist, wobei die zweite Defektschicht (24) eine Schichtdicke (D42) zwischen 0,5 µm und 40 µm und eine Defektkonzentration zwischen 1•10¹³ N/cm³ und 5•10¹⁶ N/cm³ aufweist und einen Abstand zu der Oberseite der p-dotierten Zwischenschicht (15) von höchstens die Hälfte der Schichtdicke (D5) der p-Schicht (15) aufweist.

3. III-V-Halbleiterdiode (10) nach Anspruch 1 oder Anspruch 2, **dadurch gekennzeichnet, dass** die erste Defektschicht (16) und / oder die zweite Defektschicht (24), wenn diese vorhanden ist, jeweils einen ersten Schichtbereich mit einer ersten Defektkonzentration und einen zweiten Schichtbereich mit einer zweiten Defektkonzentration aufweist.

4. III-V-Halbleiterdiode (10) nach einem der Ansprüche 1 bis 3, **dadurch gekennzeichnet, dass** die Defektkonzentration über die Schichtdicke (D41, D42) der ersten Defektschicht (16) und / oder der zweiten Defektschicht (24), wenn diese vorhanden ist, einer statistischen-Verteilung folgt.

5. III-V-Halbleiterdiode (10) nach einem der Ansprüche 1 bis 4, **dadurch gekennzeichnet, dass** die erste Defektschicht (16) und / oder die zweite Defektschicht (24), wenn diese vorhanden ist, Cr und/oder Indium und/oder Aluminium umfasst.

6. III-V-Halbleiterdiode (10) nach einem der Ansprüche 1 bis 5, **dadurch gekennzeichnet, dass** eine Gesamthöhe eines stapelförmigen Schichtaufbaus (100) bestehend aus dem p⁺-Schicht (18), der n⁻-Schicht (14), der p-dotierten Zwischenschicht und der n⁺-Schicht (12) höchstens 150-800 µm beträgt.

7. III-V- Halbleiterdiode nach einem der Ansprüche 1 bis 6, **dadurch gekennzeichnet, dass** die Schichtdicke D1 der n⁺-Schicht (12) zwischen 50 µm und 400 µm liegt.

## Claims

1. Stack-shaped III-V semiconductor diode (10), comprising
- an n⁺ layer (12) with an upper side, a lower side, a doping substance concentration of at least 10¹⁹ N/cm³ and a layer thickness (D1) of 50 - 675 µm, wherein the n⁺ layer (12) comprises a GaAs compound or consists of a GaAs compound,
- an n⁻ layer (14) with an upper side and a lower side, a doping concentration of 10¹²
- 10¹⁶ N/cm³ and a layer thickness (D2) of 10 - 300 µm, wherein the n⁻ layer (14) comprises a GaAs compound or consists of a GaAs compound,
- a p⁺ layer (18) with an upper side, a lower side, a doping concentration of 5 • 10¹⁸-5 • 10²⁰ N/cm³ and a layer thickness (D3) of 2 µm, wherein the p⁺ layer (18) comprises a GaAs compound or consists of a GaAs compound, wherein
- the layers follow one another in the stated sequence and are of monolithic construction,
- the n⁺ layer (12) is constructed as a substrate and
- the lower side of the n⁻ layer (14) is connected by material couple with the upper side of the n⁺ layer (12),
arranged between the n⁻ layer (14) and the p⁺ layer (18) is a p-doped intermediate layer (15) with a layer thickness (D5) of 1 - 50 µm and a doping substance concentration of 10¹²
- 10¹⁷ N/cm³, and with an upper side and a lower side, wherein the lower side of the p-doped intermediate layer (15) is connected by material couple with the upper side of the n⁻ layer (14) and the upper side of the p-doped intermediate layer is connected by material couple with the lower side of the p⁺ layer (18),
- wherein the stack-shaped III-V semiconductor diode (10) has a first defect layer (16) with a layer thickness (D41) between 0.5 µm and 40 µm,
- wherein the first defect layer (16) is arranged within the p-doped intermediate layer (15) and
- the first defect layer (16) has a defect concentration in the range between 1 • 10¹³ N/cm³ and 5 • 10¹⁶ N/cm³, a first contact (20) is connected by material couple with a lower side of the n⁺ layer (12) and a second contact (22) is connected by material couple with an upper side of the p⁺ layer (18).

2. III-V semiconductor diode (10) according to claim 1, **characterised in that** the semiconductor diode (10) has a second defect layer (24) within the p-doped intermediate layer (15), wherein the second defect layer (24) has a layer thickness (D42) between 0.5 µm and 40 µm and a defect concentration between 1 • 10¹³ N/cm³ and 5 • 10¹⁰ N/cm³ and a spacing from the upper side of the p-doped intermediate layer (15) of at most half the layer thickness (D5) of the p-layer (15).

3. III-V semiconductor diode (10) according to claim 1 or claim 2, **characterised in that** the first defect layer (16) and/or the second deflect layer (24) when this is present each has or each have a first layer region with a first defect concentration and a second layer region with a second defect concentration.

4. III-V semiconductor diode (10) according to any one of claims 1 to 3, **characterised in that** the defect concentration has a statistical distribution over the layer thickness (D41, D42) of the first defect layer (16) and/or the second defect layer (24) when this is present.

5. III-V semiconductor diode (10) according to any one of claims 1 to 4, **characterised in that** the first defect layer (16) and/or the second defect layer (24) when this is present comprises or comprise Cr and/or indium and/or aluminium.

6. III-V semiconductor diode (10) according to any one of claims 1 to 5, **characterised in that** an overall height of a stack-shaped layer construction (100) consisting of the p⁺ layer (18), the n⁻ layer (14), the p-doped intermediate layer and the n⁺ layer (12) is at most 150 - 800 µm.

7. III-V semiconductor diode (10) according to any one of claims 1 to 6, **characterised in that** the layer thickness D1 of the n⁺ layer (12) lies between 50 µm and 400 µm.

## Revendications

1. Diode semi-conductrice III-V à empilement (10) présentant
- une couche n⁺ (12) dotée d'une face supérieure, d'une face inférieure, d'une concentration d'agent de dopage d'au moins 10¹⁹ N/cm³ et d'une épaisseur de couche (D1) de 50 à 675 µm, la couche n⁺ (12) comprenant une liaison GaAs ou étant constituée d'une liaison GaAs,
- une couche n⁻ (14) dotée d'une face supérieure, d'une face inférieure, d'une concentration d'agent de dopage de 10¹² à 10¹⁶ N/cm³ et d'une épaisseur de couche (D2) de 10 à 300 µm, la couche n⁻ (14) comprenant une liaison GaAs ou étant constituée d'une liaison GaAs et
- une couche p⁺ (18) dotée d'une face supérieure, d'une face inférieure, d'une concentration d'agent de dopage de 5^{∗}10¹⁸ à 5^{∗}10²⁰ N/cm³ et d'une épaisseur de couche (D3) supérieure à 2 µm, la couche p⁺ (18) comprenant une liaison GaAs ou étant constituée d'une liaison GaAs,
- les couches se suivant dans l'ordre indiqué et étant monolithiques,
- la couche n⁺ (12) faisant office de substrat et
- la face inférieure de la couche n⁻ (14) étant reliée par pénétration de matière avec la face supérieure de la couche n⁺ (12),
une couche intermédiaire à dopage p (15) dotée d'une épaisseur de couche (D5) de 1 à 50 µm et d'une concentration d'agent de dopage de 10¹² à 10¹⁷ N/cm³, ainsi que d'une face inférieure et d'une face supérieure, étant disposée entre la couche n⁻ (14) et la couche p⁺ (18), la face inférieure de la couche intermédiaire à dopage p (15) étant reliée par pénétration de matière avec la face supérieure de la couche n⁻ (14) et la couche supérieure de la couche intermédiaire à dopage p étant reliée par pénétration de matière avec la face inférieure de la couche p⁺ (18),
la diode semi-conductrice III-V à empilement (10) présentant une première couche de défaut (16) d'une épaisseur de couche (D41) située entre 0,5 µm et 40 µm,
- la première couche de défaut (16) étant disposée à l'intérieur de la couche intermédiaire à dopage p (15),
- la première couche de défaut (16) présentant une concentration de défaut située sur une plage entre 1^{∗}10¹³ N/cm³ et 5^{∗}10¹⁶ N/cm³, et un premier contact (20) étant relié par pénétration de matière avec une face inférieure de la couche n⁺ (12) et un deuxième contact (22) étant relié par pénétration de matière avec une face supérieure de la couche p⁺ (18).

2. Diode semi-conductrice III-V (10) selon la revendication 1, **caractérisée en ce qu'**elle présente une deuxième couche de défaut (24) à l'intérieur de la couche intermédiaire à dopage p (15), la deuxième couche de défaut (24) présentant une épaisseur de couche (D42) située entre 0,5 µm et 40 µm et une concentration de défaut située entre 1^{∗}10¹³ N/cm³ et 5^{∗}10¹⁶ N/cm³ et présentant une distance par rapport à la face supérieure de la couche intermédiaire à dopage p (15) égale au maximum à la moitié de l'épaisseur de couche (D5) de la couche p (15).

3. Diode semi-conductrice III-V (10) selon la revendication 1 ou la revendication 2, **caractérisée en ce que** la première couche de défaut (16) et/ou la deuxième couche de défaut (24), si celle-ci est présente, comprennent chacune une première région de couche dotée d'une première concentration de défaut et une deuxième région de couche dotée d'une deuxième concentration de défaut.

4. Diode semi-conductrice III-V (10) selon une des revendications 1 à 3, **caractérisée en ce que** la concentration de défaut sur l'épaisseur de couche (D41, D42) de la première couche de défaut (16) et/ou de la deuxième couche de défaut (24), si celle-ci est présente, suit une distribution statistique.

5. Diode semi-conductrice III-V (10) selon une des revendications 1 à 4, **caractérisée en ce que** la première couche de défaut (16) et/ou de la deuxième couche de défaut (24), si celle-ci est présente, comprend du Cr et/ou de l'indium et/ou de l'aluminium.

6. Diode semi-conductrice III-V (10) selon une des revendications 1 à 5, **caractérisée en ce qu'**une hauteur totale d'une structure en couches empilées (100) constituée de la couche p⁺ (18), de la couche n⁻ (14), de la couche intermédiaire à dopage p et de la couche n⁺ (12) est au maximum de 150 à 800 µm.

7. Diode semi-conductrice III-V selon une des revendications 1 à 6, **caractérisée en ce que** l'épaisseur de couche (D1) de la couche n⁺ (12) se situe entre 50 µm et 400 µm.
